Europäisches Patentamt
European Patent Office
Office européen des brevets

(19) Veröffentlichungsnummer: **0 267 437 A2**

# (12) EUROPÄISCHE PATENTANMELDUNG

(21) Anmeldenummer: 87114831.8

(22) Anmeldetag: 10.10.87

(51) Int. Cl.4: C07C 87/30 , C07C 91/26 , H05K 3/06

(30) Priorität: 11.11.86 DE 3638629

(43) Veröffentlichungstag der Anmeldung: 18.05.88 Patentblatt 88/20

(84) Benannte Vertragsstaaten: BE CH DE ES FR GB IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Meyer, Walter
Klosterheider Weg 18
D-1000 Berlin 28(DE)
Erfinder: Marock, Günter
Eisenacher Strasse 89
D-1000 Berlin 30(DE)

## (54) Mittel und Verfahren zur Entfernung von Fotoresisten.

(57) Die Erfindung betrifft ein Mittel zur Entfernung von Fotoresisten auf Leiterplatten, gekennzeichnet durch einen Gehalt an quaternären Alkylammoniumhydroxiden der allgemeinen Formel

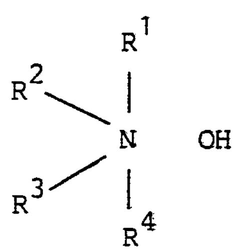

worin $R^1$, $R^2$, $R^3$ und/oder $R^4$ jeweils gegebenenfalls substituierte organische Reste, vorzugsweise Alkylreste oder Hydroxialkylreste, bedeuten.

EP 0 267 437 A2

# MITTEL UND VERFAHREN ZUR ENTFERNUNG VON FOTORESISTEN

Die Erfindung betrifft ein Mittel zur Entfernung von Fotoresisten auf Leiterplatten sowie ein Verfahren unter Verwendung dieses Mittels.

Fotoresiste sind bekannte Hilfsmittel zur präzisierten Übertragung von Masken auf unterschiedliche Trägermaterialien, wie sie zum Beispiel zur Herstellung gedruckter Schaltungen erforderlich sind.

In Abhängigkeit von der Aufgabenstellung und des gewählten Fertigungsverfahrens stehen unterschiedliche Resisttypen zur Verfügung, von denen die alkalilöslichen für verschiedene Zwecke besonders geeignet sind.

Das Entfernen dieser Fotoresistschichten erfolgt in der Regel mit einer Alkalihydroxid-Lösung. Problematisch wird die Entfernung des Fotoresistes dann, wenn beim galvanischen Leiteraufbau die Kupfer-und Zinn-Blei-Schicht den Fotoresist überwachsen hat, wobei die Metallabscheidung vom Leiterbahnkanal sich pilzförmig über die Ränder des Fotoresists legt. Diese Erscheinung ist bei der Anwendung von Feinleitern oder bei der ungleichmäßigen Anordnung der Leiterbahnen innerhalb des gesamten Leiterbahnbildes kaum zu vermeiden, da elektrische oder funktionelle Forderungen des Leiterbahndesigns solche galvanotechnisch unvorteilhafte Anordnungen bedingen.

Auch bei der Anwendung von breiten Leiterbahnen mit entsprechenden Leiterbahnabständen ist die Ausbildung größerer Resistfladen verfahrensstörend, da beim Ablösen sich diese Fladen über bereits gestrippte Leiterbahnpartien legen können. Die nicht vollständige Entfernung des Fotoresists führt durch unvollständiges Ätzen im abschließenden Verfahrensschritt unweigerlich zu Ausschuß oder zu erheblicher Nacharbeit.

Aufgabe der vorliegenden Erfindung ist daher die Entwicklung eines Mittels, mit dem sich Fotoresiste von Leiterplatten problemlos entfernen lassen.

Die Lösung dieser Aufgabe erfolgt durch den im Patentanspruch 1 gekennzeichneten Gegenstand.

Vorteilhafte Ausgestaltungen der Erfindung sind in den Unteransprüchen aufgeführt.

Das erfindungsgemäße Mittel hat überraschenderweise den besonderen Vorteil, daß sich bei dessen Einwirkung Resiste in Form kleiner Partikel auch aus überwachsenen Kupfer-Zinn-Bleischichten lösen und außerdem mit normalem Aufwand aus dieser Lösung filtrierbar sind.

Die erfindungsgemäß zu verwendenden Verbindungen sind an sich bekannt oder können nach an sich bekannten Verfahren hergestellt werden.

Als besonders geeignete Verbindungen sind solche zu nennen, bei denen bei Reste R Alkylreste oder Hydroxyalkylreste, wie Methyl, Äthyl, Hydroxyäthyl oder Propyl etc. darstellen.

Herausragende Wirkungen entfallen von diesen Verbindungen auf $\beta$-Hydroxiäthyltrimethylammoniumhydroxid, Tetramethylammoniumhydroxid sowie Bis-(2-hydroxyethyl)-dimethyl-ammoniumhydroxid.

Als alkalische Lösungen eignen sich insbesondere Alkalihydroxid-Lösungen vorzugsweise Kaliumhydroxid-Lösungen in Konzentrationen von 10 bis 5o g/Liter.

Die Arbeitstemperaturen liegen im Bereich von etwa 20° bis 70° C.

Die Behandlungsdauer beträgt etwa 0,5 bis 10 Minuten.

Das erfindungsgemäße Mittel eignet sich zur Entfernung beziehungsweise für das sogenannte Strippen aller an sich bekannten alkalilöslichen Fotoresiste, wodurch der Stand der Technik auf dem Gebiet der Leiterplattentechnik erheblich bereichert wird.

Das nachfolgende Beispiel dient zur Erläuterung der Erfindung.

## BEISPIEL

Bei der Herstellung von Leiterplatten im Subtraktivverfahren wird auf der kupferkaschierten und durchkontaktierten Leiterplatte die Oberfläche mit einem Fotoresistfilm laminiert, dann wird die Oberfläche so belichtet und entwickelt, daß die späteren Leiterbahnen und die Bohrlöcher wieder freigelegt werden, so daß sie nach entsprechender Vorbehandlung elektrolytisch bis zur gewünschten Schichtdicke verkupfert und anschließend zum Beispiel mit einer lötfähigen Endschicht von Zinn-Blei, die gleichzeitig als Ätzresist dient, versehen werden können. Nach dem Abschluß der elektrolytischen Prozesse wird die Fotoresistschicht gestrippt, die dann freigelegten Kupferflächen geätzt, so daß dann die strukturierte Leiterplatte vorliegt.

Das erfindungsgemäße Mittel wird hierbei wie folgt eingesetzt.

a) Vorstrippen in einer Lösung von 10 bis 50 g/Liter KOH und 10 bis 200 g/Liter $\beta$-Hydroxiäthyl-Trimethylammoniumhydroxid, Temperatur 20 bis 70° C, 0,5 bis 10 Minuten.

b) Spritzspülen mit 1 bis 60 Bar Wasserdruck.

c) Nachstrippen in einer Lösung der unter a) beschriebenen Zusammensetzung.

d) Spritzpülen wie unter b) beschrieben.

Das Spritzspülen stellt dabei einen Sicherheitsfaktor dar, da auch bei einer Stripperlösung, die durch Resistbelastung nicht mehr optimale Ablösungergebnisse bringt, durch den Spritzspülstrahl eine mechanische Unterstützung des Ablösevorganges erfolgt.

Nach der Erschöpfung der Stripperlösung im Vorstrippbehälter kann die Stripperlösung durch Absenken des pH-Wertes auf 2-3 und anschließendes Anheben des pH-Wertes auf den alkalischen Arbeitswert des Strippers von einem erheblichen Teil der organischen Belastung durch den Fotoresist befreit werden. Die gelösten Bestandteile des Fotoresistes fallen dabei aus, können abfiltriert werden und der Stripper kann nach dem Ausgleich der Konzentrationsverluste wieder eingesetzt werden.

Nach der endgültigen Erschöpfung des Vorstrippers nach einem Durchsatz von etwa 10 $m^2$ Fotoresist /1 wird der Nachstripper, der nur gering mit Fotoresist belastet ist in die Vorstripperwanne gepumpt, der Nachstripper neu angesetzt, so daß die doppelte Verwendung der Verfahrenslösung ein besonders wirtschaftliches Arbeiten gestattet.

Analoge Ergebnisse wurden unter Verwendung von Tetramethylammoniumhydroxid und Bis-(2-hydroxyethyl)-dimethyl-ammoniumhydroxid zum Vorstrippen erhalten.

## Ansprüche

1. Mittel zur Entfernung von Fotoresisten auf Leiterplatten, gekennzeichnet durch einen Gehalt an quaternären Alkylammoniumhydroxiden der allgemeinen Formel

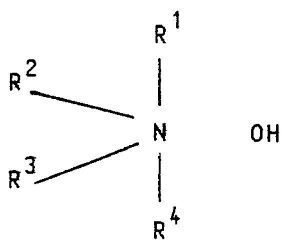

worin $R^1$, $R^2$, $R^3$ und/oder $R^4$ jeweils gegebenenfalls substituierte organische Reste, vorzugsweise Alkylreste oder Hydroxialkylreste, bedeuten.

2. Mittel gemäß Anspruch 1, worin $R_1$ ein Hydroxyalkylrest ist.

3. Mittel gemäß Ansprüchen 1 und 2, gekennzeichnet durch einen Gehalt an $\beta$-Hydroxiäthyltrimethylammoniumhydroxid.

Mittel gemäß Anspruch 1, gekennzeichnet durch einen Gehalt an Tetramethylammoniumhydroxid.

5. Mittel gemäß Ansprüchen 1 und 2, gekennzeichnet durch einen Gehalt an Bis-(2-hydroxyethyl)-dimethyl-ammoniumhydroxid.

6. Mittel gemäß Anspruch 1, dadurch gekennzeichnet, daß diese eine wässrige alkalische Lösung darstellt.

7. Mittel gemäß Anspruch 1, enthaltend quaternäre Alkylammoniumhydroxide in Konzentrationen von 10 bis 200 g/Liter.

8. Mittel gemäß Anspruch 1, enthaltend 10 bis 50 g/Liter Alkalihydroxid.

9. Mittel gemäß Anspruch 8, enthaltend als Alkalihydroxid Kaliumhydroxid.

10. Verfahren zur Entfernung von Fotoresisten auf Leiterplatten durch Verwendung eines Mittels gemäß Ansprüchen 1 bis 9 bei Temperaturen von 20° bis 70° C.



BAD ORIGINAL